# EUROPÄISCHE PATENTANMELDUNG

(11) **EP 4 404 698 A1**
(43) Veröffentlichungstag der Anmeldung: **24.07.2024**
(21) Anmeldenummer: 24150539.5
(22) Anmeldetag: 05.01.2024
(51) Int. Cl.: H05K 5/06, G01F 15/14

(54) **LUFTDICHTES GEHÄUSE, FLUIDZÄHLEREINRICHTUNG UND VERFAHREN ZUR HERSTELLUNG EINES GEHÄUSES**

(30) Priorität: 18.01.2023 DE 102023101203
(71) Anmelder: Diehl Metering GmbH, 91522 Ansbach (DE)
(72) Erfinder: Schmidt, Axel, 91522 Ansbach (DE); Seifert, Andreas, 91743 Unterschwaningen (DE); Zellner, Claus, 91522 Ansbach (DE); Sturm, Thomas, 91623 Sachsen (DE); Hünenberger, Patrick, 91522 Ansbach (DE)
(74) Vertreter: Diehl Patentabteilung

(57) **Zusammenfassung**

Luftdichtes Gehäuse (1), insbesondere Elektronikgehäuse, zum Einsatz in unterschiedlichen Umgebungsdruckverhältnissen, aufweisend aus einem Kunststoffmaterial bestehende Gehäusewände (2, 3), wobei wenigstens eine der Gehäusewände (3) ein eine Aussparung in der Gehäusewand (3) luftdicht verschließendes Druckausgleichsmittel (4) mit einem elastischen, flächigen, über der Aussparung liegenden Ausgleichselement (6) aufweist.

## Beschreibung

Die Erfindung betrifft ein luftdichtes Gehäuse, insbesondere ein Elektronikgehäuse, zum Einsatz in unterschiedlichen Umgebungsdruckverhältnissen, aufweisend aus einem Kunststoffmaterial bestehende Gehäusewände. Daneben betrifft die Erfindung eine Fluidzählereinrichtung sowie ein Verfahren zur Herstellung eines solchen luftdichten Gehäuses.

In einer Vielzahl von Anwendungen besteht, insbesondere für Elektronikbauteile, der Wunsch nach einem optimalen, über einen bloßen Staub- und Flüssigkeitsschutz hinausgehenden Schutz von in einem Gehäuse aufzunehmenden Komponenten. Dies ist beispielsweise für Fluidzählereinrichtungen, insbesondere Wasserzähler und/oder Gaszähler und/oder Wärmezähler, oder die Kommunikationsmodule, beispielsweise Funkmodule, solcher Fluidzählereinrichtungen der Fall, die in unterschiedlichsten teils widrigen Umgebungsverhältnissen eingesetzt werden sollen und dabei robust und funktionssicher sein sollen. Für derartige Anwendungen wurde im Stand der Technik bereits vorgeschlagen, Elektronikkomponenten oder sonstige zu schützende Komponenten zur Bildung des sie umfassenden Gehäuses vollständig einzugießen. Dabei ist es zum einen bekannt, vollständig aushärtende, formgebende Vergussmassen zu verwenden, so dass beispielsweise bei Elektronikkomponenten ein sogenanntes gemoldetes Elektronikmodul entstehen kann. Eine andere Herangehensweise sieht vor, einen formgebenden Rahmen zu verwenden und einen Gel-Verguss der innerhalb des Rahmens anzuordnenden Komponenten anzustreben (sogenanntes Rahmenmodul).

Obgleich diese Lösungen einen guten Schutz, insbesondere auch einen luftdichten Abschluss der Komponenten bieten, weisen sie auch Nachteile auf. Beispielsweise gestaltet sich bei Elektronikkomponenten das Recycling als äußerst schwierig. Ferner wird eine große Menge Materials als Vergussmasse benötigt, wodurch auch das Gesamtgewicht des Gehäuses mit den darin aufgenommenen Komponenten steigt.

Mithin wurde angedacht, luftdichte, Gehäusewände umfassende Gehäuse aus Kunststoff zu verwenden, in deren inneren Hohlraum die Komponenten, insbesondere Elektronikkomponenten, anzuordnen sind. Derartige Gehäuse sollen, beispielsweise bei Fluidzählereinrichtungen, jedoch bei unterschiedlichsten Umgebungsbedingungen und somit auch unterschiedlichsten Umgebungsdruckbedingungen eingesetzt werden, wobei unterschiedliche Druckverhältnisse innerhalb des luftdichten Gehäuses und außerhalb des luftdichten Gehäuses beispielsweise durch Temperaturänderungen, Wettereffekte und dergleichen auftreten können. Auch verschiedene geographische Höhen bei der Herstellung und am späteren Einsatzort können zu Differenzdrücken gegenüber der Umgebung führen. Dieser Druckunterschied kann nachteilig auf das Gehäuse wirken, da die Gehäusewände durch die Druckdifferenz belastet werden und somit, insbesondere über ihre Lebensdauer, beschädigt werden können und zu einer Öffnung führen können, durch die Luft, Feuchtigkeit, Schmutz und Flüssigkeiten eintreten können.

Im Stand der Technik sind diesbezüglich Lösungen bekannt, die Membranen einsetzen, welche für Staub und Wasser undurchdringlich sind, jedoch einen Luftaustausch ermöglichen, sodass sich ein Druckausgleich einstellt. Derartige Membranen können jedoch immer dann nicht eingesetzt werden, wenn auch Luftdichtheit des Gehäuses gefordert wird, beispielsweise um auch das Eindringen feuchter Luft und dergleichen zu verhindern.

Der Erfindung liegt daher die Aufgabe zugrunde, die Belastung von Gehäuseteilen bei unterschiedlichen Umgebungsverhältnissen und somit den Schutz darin luftdicht aufgenommener Komponenten, insbesondere von Elektronikkomponenten, zu verbessern.

Zur Lösung dieser Aufgabe ist bei einem luftdichten Gehäuse der eingangs genannten Art erfindungsgemäß vorgesehen, dass wenigstens eine der Gehäusewände ein eine Aussparung in der Gehäusewand luftdicht verschließendes Druckausgleichsmittel mit einem elastischen, flächigen, über der Aussparung liegenden Ausgleichselement aufweist.

Erfindungsgemäß wird also ein elastisches, luftdichtes Ausgleichselement als Teil des luftdichten Gehäuses vorgeschlagen. Im Bereich einer Aussparung der, insbesondere thermoplastischen, formstabilen Gehäusewand trennt das elastische Ausgleichselement mithin das Gehäuseinnere, also einen inneren Hohlraum des Gehäuses, von der Umgebung. Dies führt dazu, dass bei Auftreten einer Druckdifferenz zwischen dem Gehäuseinneren und der Umgebung das Ausgleichselement in eine entsprechende Richtung ausgelenkt werden kann, wobei diese Auslenkung sowohl nach innen als auch nach außen erfolgen kann. Diese Auslenkung des Luftausgleichselements führt zu einer Erhöhung oder Reduzierung des in dem luftdichten Gehäuse eingeschlossenen Luftvolumens. Aufgrund des Zusammenhangs zwischen dem Druck und dem Volumen innerhalb eines abgeschlossenen Innenraumes führt dies zu einem Druckausgleich des Inneren des luftdichten Gehäuses zur Umgebung.

Auf diese Weise erlaubt das Druckausgleichselement eine Reduzierung der Belastung der Gehäuseteile des luftdichten Gehäuses, insbesondere der Gehäusewände, durch Druckunterschiede zwischen dem Gehäuseinneren und der Umgebung, wie sie beispielsweise durch Temperaturänderungen, Wettereffekte und unterschiedliche geographische Höhen hervorgerufen werden können. Dabei wird die Luftdichtigkeit des Gehäuses weiterhin sichergestellt, sodass kein Luftstrom, kein Eintrag von feuchter Luft und somit kein zusätzlicher Eintrag von Feuchtigkeit in das luftdichte Gehäuse erfolgt.

Hierbei kann es sich bei dem Gehäuse insbesondere um ein luftdichtes Elektronikgehäuse handeln, welches als zu schützende Komponenten mithin Elektronikkomponenten aufnimmt. Beispielsweise kann innerhalb des Gehäuses eine wenigstens ein Elektronikbauteil, beispielsweise einen Chip oder dergleichen, tragende Leiterplatte angeordnet sein und verbessert und dauerhaft geschützt werden.

Das Ausgleichselement kann beispielsweise als eine flexible und elastische Ausgleichsmembran, die luftdicht ist, ausgebildet sein.

Mit besonderem Vorteil kann das Ausgleichselement aus einem elastomerischen Material, insbesondere einem thermoplastischen Elastomer (TPE), bestehen. Dabei ist das Druckausgleichsmittel mit besonderem Vorteil einstückig ausgebildet, sodass es insgesamt aus einem elastomerischen Material, insbesondere einem thermoplastischen Elastomer, bestehen kann. Damit kann eine Ausgestaltung gegeben sein, in der sowohl das Gehäuse als auch das Druckausgleichsmittel aus Kunststoff bestehen, wobei das Gehäuse insbesondere aus einem thermoplastischen, formstabilen bzw. harten Kunststoff bestehen kann, das Druckausgleichsmittel und somit das Druckausgleichselement aus einem die gewünschten elastischen Eigenschaften aufweisenden weichen Kunststoff, insbesondere TPE.

Das Druckausgleichsmittel kann einen Verbindungsabschnitt zur Halterung in der Aussparung und zur Abdichtung aufweisen. Hierbei ist für den Verbindungsabschnitt insbesondere ein wenigstens einseitiger Überlapp mit der Gehäusewand am Rand der Aussparung gegeben, wo die luftdichte Halterung beziehungsweise Verbindung hergestellt ist. Bei Einstückigkeit des Druckausgleichsmittel kann dieses beispielsweise über der Aussparung flächig liegend das Ausgleichselement umfassen, während nach außen am Rand der Aussparung der Verbindungsabschnitt anschließt.

In diesem Zusammenhang ist es von besonderem Vorteil, wenn der Verbindungsabschnitt des einstückigen Druckausgleichsmittels durch Stoffschluss an dem gehäusewandseitigen Rand der Aussparung gehaltert ist. Ein Stoffschluss stellt bereits die gewünschte Luftdichtigkeit her und ist daher besonders vorteilhaft.

In diesem Kontext sieht eine allgemeine, besonders vorteilhafte Ausgestaltung vor, dass wenigstens die das Druckausgleichsmittel umfassende Gehäusewand und das Druckausgleichsmittel durch Zweikomponenten-Spritzguss gefertigt sind. Auf diese Weise wird das Druckausgleichsmittel einstückig hergestellt und durch Stoffschluss einfach, robust und luftdicht an die Gehäusewand am Rand der Aussparung angebunden. Hierbei kann in einem ersten Schritt aus einem Duroplast als erste Komponente wenigstens die das Druckausgleichsmittel umfassende Gehäusewand, gegebenenfalls auch das gesamte Gehäuse, spritzgegossen werden, wonach in einem zweiten Schritt mit einem weichen Kunststoff, beispielsweise einem thermoplastischen Elastomer, das Druckausgleichsmittel hinzugefügt wird und die Aussparung in der Gehäusewand durch das elastische Druckausgleichsmittel überdeckt wird. Die entstehende stoffschlüssige Verbindung stellt die Luftdichtigkeit des Gesamtgehäuses sicher. Alternative, jedoch weniger bevorzugte Ausführungsbeispiele können auch vorsehen, dass die Gehäusewand mit der Aussparung sowie das Druckausgleichsmittel separat gefertigt werden und in einem späteren Schritt zusammengefügt werden, beispielsweise durch stoffschlüssige Verbindungen wie verkleben oder anderweitig luftdicht schließende Befestigungsmittel.

Dabei sei an dieser Stelle noch angemerkt, dass, insbesondere zusätzlich zu einer stoffschlüssigen Befestigung des Druckausgleichsmittels an der Gehäusewand, auch eine Befestigung durch Formschluss grundsätzlich denkbar ist, beispielsweise durch ein Umgreifen des Randes der Aussparung mittels des Verbindungsabschnitts. Eine besonders vorteilhafte, robust und zuverlässig Luftdichtigkeit und Befestigung bietende Ausgestaltung ergibt sich dabei, wenn die stoffschlüssige und formschlüssige Verbindung im Zweikomponenten-Spritzgussverfahren gefertigt ist, insbesondere durch Umgreifen des Randes der Aussparung durch den Verbindungsabschnitt des einstückigen Druckausgleichsmittels.

Die Aussparung kann vorteilhafterweise rund, insbesondere kreisförmig, sein. Dies hat sich hinsichtlich der bei einer Auswölbung oder Einwölbung durch eine Druckdifferenz auftretenden Kräfte und deren Verteilung als eine optimale Lösung erwiesen. Zudem ergibt sich durch die Symmetrie, insbesondere bei kreisförmiger Aussparung, ein geringerer Widerstand gegen die Verformung zum Druckausgleich.

Das erfindungsgemäße Gehäuse lässt sich mit besonderem Vorteil bei Fluidzählereinrichtungen, beispielsweise Wasserzählern und/oder Gaszählern und/oder Wärmezählern, für die dort verwendete Elektronik, insbesondere zumindest Anteile einer entsprechenden Steuereinrichtung, und/oder für Kommunikationsmodule, insbesondere Funkmodule, einsetzen. Gerade was Fluidzählereinrichtungen angeht, besteht sowohl der Wunsch nach Luftdichtheit zum idealen Schutz der Elektronik, zum anderen aber der Einsatz unter unterschiedlichsten Umgebungsbedingungen, denen das luftdichte Gehäuse in der erfindungsgemäßen Ausgestaltung bei aufrechterhaltener Luftdichtigkeit verbessert standhalten kann.

Die Erfindung betrifft daher auch eine Fluidzählereinrichtung, insbesondere einen Wasserzähler und/oder einen Gaszähler, umfassend ein Zählwerk und eine Steuereinrichtung, welche wenigstens teilweise in einem erfindungsgemäßen Gehäuse angeordnet ist. Sämtliche Ausführungen bezüglich des erfindungsgemäßen Gehäuses lassen sich analog auf die erfindungsgemäße Fluidzählereinrichtung übertragen, mit welcher mithin die bereits genannten Vorteile erhalten werden können. Beispielsweise kann es sich bei der Fluidzählereinrichtung um eine Ultraschall-Messeinrichtung handeln, für die besonders zu schützende Elektronikkomponenten als Teil der Steuereinrichtung vorliegen.

Schließlich betrifft die Erfindung auch ein Verfahren zur Herstellung eines erfindungsgemäßen Gehäuses, welches sich dadurch auszeichnet, dass wenigstens die das Druckausgleichsmittel aufweisende Gehäusewand durch Zweikomponenten-Spritzgießen gefertigt wird. Wie bereits dargelegt, wird hierbei vorzugsweise unmittelbar ein Stoffschluss herbeigeführt, der die Luftdichtigkeit robust aufrechterhält. Dabei kann als Komponente für die Gehäusewand ein thermoplastischer Kunststoff und als Komponente für das Druckausgleichsmittel ein thermoplastisches Elastomer verwendet werden. In einer zweckmäßigen Weiterbildung kann durch das Zweikomponenten-Spritzgießen, wie bereits erwähnt, auch ein Formschluss zwischen der Gehäusewand und dem Druckausgleichsmittel hergestellt werden, insbesondere durch Umgreifen der Gehäusewand mittels des Druckausgleichsmittels in einem Verbindungsabschnitt. Auch bezüglich des Verfahrens gelten die Ausführungen zum erfindungsgemäßen luftdichten Gehäuse selbstverständlich fort.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: eine schematische, perspektivische Ansicht eines erfindungsgemäßen Gehäuses,
- Fig. 2: eine teilweise Querschnittsansicht des Gehäuses entlang der Linie II - II in Fig. 1,
- Fig. 3: die Querschnittsansicht der Fig. 2 bei Vorliegen eines ersten geänderten Umgebungsdrucks,
- Fig. 4: die Querschnittsansicht der Fig. 2 bei Vorliegen eines zweiten geänderten Umgebungsdrucks,
- Fig. 5: eine schematische, komplette Querschnittsansicht des Gehäuses entlang der Linie V - V in Fig. 1, und
- Fig. 6: eine schematische Prinzipskizze einer erfindungsgemäßen Fluidzählereinrichtung.

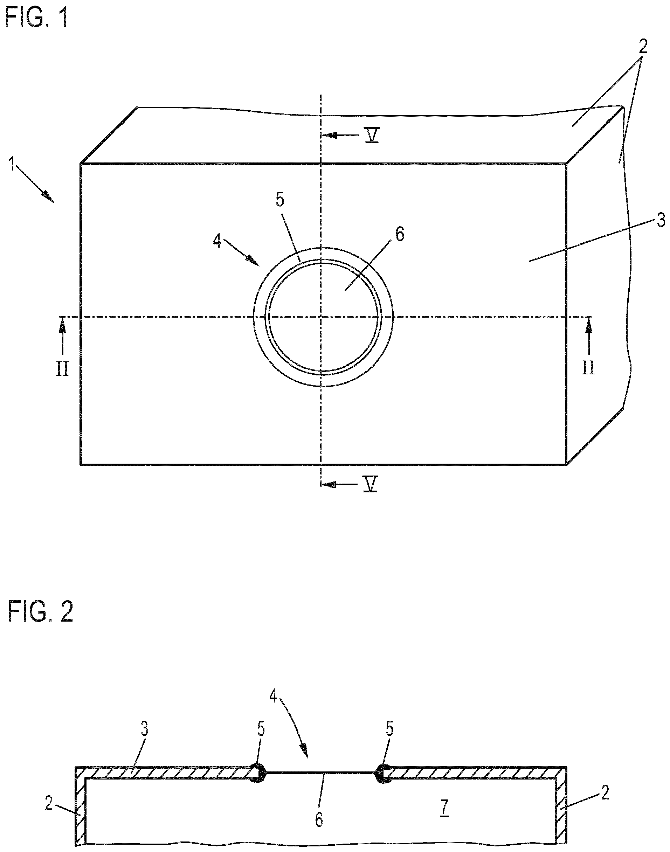

Fig. 1 zeigt eine Außenansicht eines erfindungsgemäßen luftdichten Gehäuses 1, welches vorliegend eine Quaderform aufweist, die durch einen inneren Hohlraum begrenzende, insbesondere nichtelastische bzw. steife, Gehäusewände 2, 3 gebildet ist. Die Gehäusewände 2, 3 bestehen aus einem thermoplastischen Kunststoff. Eine kreisförmige Aussparung in der Gehäusewand 3 ist durch ein Druckausgleichsmittel 4 verschlossen, welches durch Stoffschluss und Formschluss gehaltert ist. Das einstückige Druckausgleichsmittel 4 umfasst einen Verbindungsabschnitt 5 zur Halterung in der Aussparung sowie ein flächiges, elastisches, zentrales, die Aussparung überdeckendes Ausgleichselement 6.

Das Gehäuse 1 wurde im Zweikomponenten-Spritzgussverfahren hergestellt, wobei zunächst die Gehäusewände 2, 3 aus dem thermoplastischen Kunststoff als erste Komponente gebildet wurden, wonach in einem weiteren Schritt aus einem thermoplastischen Elastomer als zweite Komponente das Druckausgleichsmittel 4 gebildet wurde.

Die teilweise Querschnittsansicht entlang der Linie II - II in Fig. 1, die in Fig. 2 dargestellt ist, zeigt den Zustand des Druckausgleichsmittels 4 und insbesondere des Ausgleichselements 6 bei einem Umgebungsdruck, der dem Druck im Inneren des Gehäuses 1 bei luftdichtem Abschluss des Gehäuses 1 entspricht. Das Ausgleichselement 6 befindet sich dann in einer die Gehäusewand 3 durch die Aussparung geradlinig fortsetzenden Grundstellung, in der kein Druckausgleich erforderlich ist, da keine Druckdifferenz zwischen der Umgebung und dem Gehäuseinneren 7 vorliegt. Dabei ist in Fig. 2 auch erkennbar, wie der Verbindungsabschnitt 5 des einstückigen Druckausgleichsmittels 4 die Gehäusewand 3 am Rand der Aussparung umgreift, um zusätzlich zu einem Stoffschluss zwischen dem thermoplastischen Kunststoff und dem thermoplastischen Elastomer auch einen Formschluss herbeizuführen.

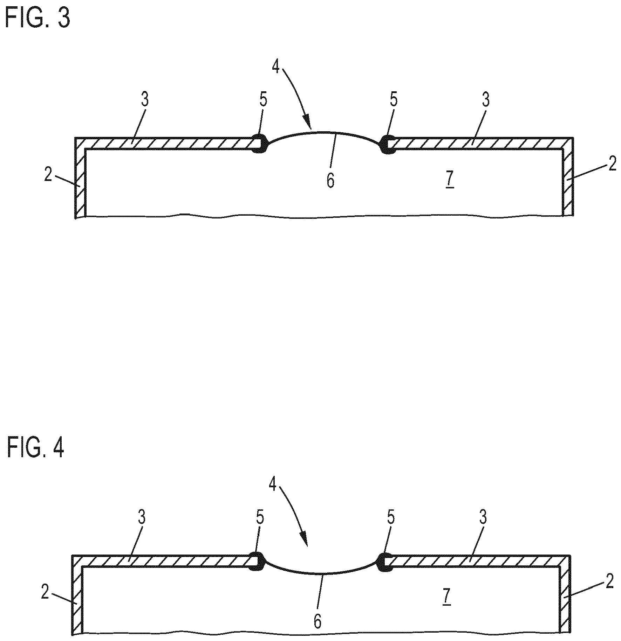

Liegt nun ein Umgebungsdruck vor, der geringer als der Druck im Gehäuseinneren 7 ist, wird das elastische Ausgleichselement verformt und wölbt sich nach außen, sodass sich das Volumen für die Luft im Gehäuseinneren 7 vergrößert und der Druckunterschied ausgeglichen wird, wie in Fig. 3 dargestellt.

Fig. 4 zeigt den umgekehrten Fall, in dem ein Überdruck in der Umgebung gegenüber dem Gehäuseinneren 7 aufgetreten ist und zu einer Verformung des elastischen Ausgleichselements 6 nach innen, mithin einer Wölbung nach innen, geführt hat.

Auf diese Weise sorgt das elastische Ausgleichselement 6 des Druckausgleichsmittels 4 für einen Druckausgleich zwischen dem Gehäuseinneren 7 und der Umgebung, ohne die Luftdichtheit zu beeinträchtigen.

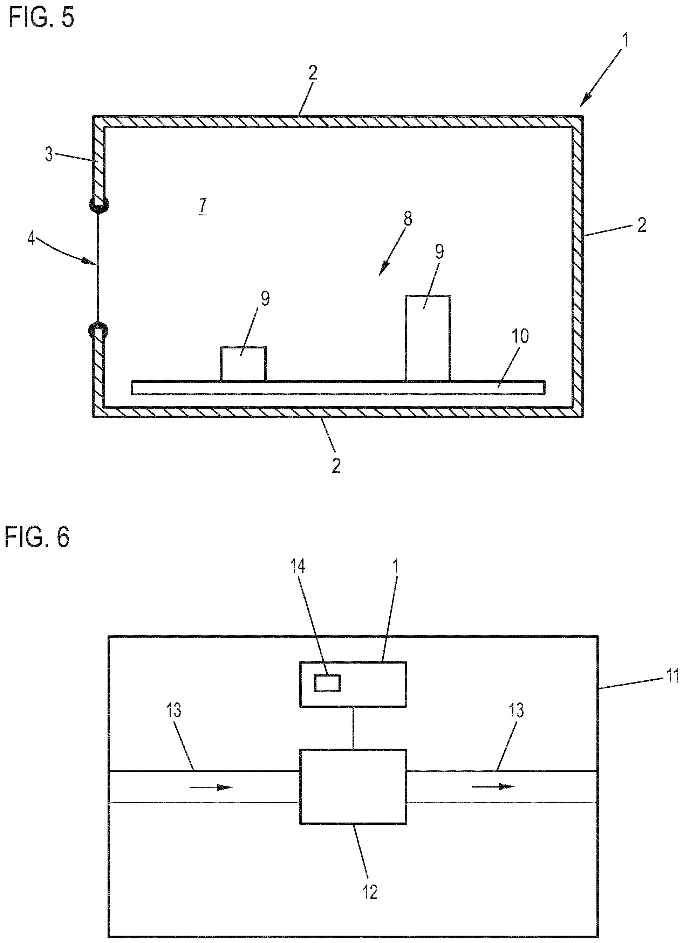

Fig. 5 zeigt in einer vollständigen Querschnittsansicht entlang der Linie V - V der Fig. 1, dass es sich bei dem luftdichten Gehäuse 1 vorliegend um ein Elektronikgehäuse handelt, in welchem Elektronikkomponenten 8, vorliegend Elektronikbauteile 9 auf einer Leiterplatte 10, geschützt angeordnet sind.

Fig. 6 zeigt schließlich schematisch eine erfindungsgemäße Fluidzählereinrichtung 11, beispielsweise einen Wasserzähler. Dabei ist ein Zählwerk 12 an entsprechende Leitungsabschnitte 13 für das Fluid angeschlossen. Der Betrieb der Fluidzählereinrichtung 11 wird durch eine Steuereinrichtung 14 gesteuert, welche wenigstens teilweise in einem luftdichten Gehäuse 1 gemäß der vorliegenden Erfindung angeordnet ist. Bei dem Zählwerk 12 kann es sich beispielsweise um ein Ultraschall-Zählwerk handeln.

### Bezugszeichenliste

- 1: luftdichtes Gehäuse
- 2: Gehäusewand
- 3: Gehäusewand
- 4: Druckausgleichsmittel
- 5: Verbindungsabschnitt
- 6: Ausgleichselement
- 7: Gehäuseinneres
- 8: Elektronikkomponente
- 9: Elektronikbauteil
- 10: Leiterplatte
- 11: Fluidzählereinrichtung
- 12: Zählwerk
- 13: Leitungsabschnitt
- 14: Steuereinrichtung

## Patentansprüche

1. Luftdichtes Gehäuse (1), insbesondere Elektronikgehäuse, zum Einsatz in unterschiedlichen Umgebungsdruckverhältnissen, aufweisend aus einem Kunststoffmaterial bestehende Gehäusewände (2, 3), **dadurch gekennzeichnet, dass** wenigstens eine der Gehäusewände (3) ein eine Aussparung in der Gehäusewand (3) luftdicht verschließendes Druckausgleichsmittel (4) mit einem elastischen, flächigen, über der Aussparung liegenden Ausgleichselement (6) aufweist.

2. Gehäuse nach Anspruch 1, **dadurch gekennzeichnet, dass** das Ausgleichselement (6) aus einem elastomerischen Material, insbesondere einem thermoplastischen Elastomer, besteht.

3. Gehäuse nach Anspruch 1 oder 2, **dadurch gekennzeichnet, dass** das Druckausgleichsmittel (4) einen Verbindungsabschnitt (5) zur Halterung in der Aussparung und zur Abdichtung aufweist.

4. Gehäuse nach Anspruch 3, **dadurch gekennzeichnet, dass** der Verbindungsabschnitt (5) des einstückigen Druckausgleichmittels (4) durch Stoffschluss an dem gehäusewandseitigen Rand der Aussparung gehaltert ist.

5. Gehäuse nach Anspruch 4, **dadurch gekennzeichnet, dass** zusätzlich zu dem Stoffschluss auch ein Formschluss mittels des Verbindungsabschnitts (5) vorgesehen ist, insbesondere der Verbindungsabschnitt (5) die Gehäusewand (3) am Rand der Aussparung umgreift.

6. Gehäuse nach einem der vorangehenden Ansprüche, **dadurch gekennzeichnet, dass** wenigstens die das Druckausgleichsmittel (4) umfassende Gehäusewand (3) und das Druckausgleichsmittel (4) durch Zweikomponenten-Spitzguss gefertigt sind.

7. Gehäuse nach einem der vorangehenden Ansprüche, **dadurch gekennzeichnet, dass** die Aussparung rund, insbesondere kreisförmig, ist.

8. Gehäuse nach einem der vorangehenden Ansprüche, **dadurch gekennzeichnet, dass** innerhalb des Gehäuses (1) eine wenigstens ein Elektronikbauteil (9) tragende Leiterplatte (10) angeordnet ist.

9. Fluidzählereinrichtung (11), umfassend ein Zählwerk (12) und eine Steuereinrichtung (14), welche wenigstens teilweise in einem Gehäuse (1) nach einem der vorangehenden Ansprüche angeordnet ist.

10. Verfahren zur Herstellung eines Gehäuses (1) nach einem der Ansprüche 1 bis 8, **dadurch gekennzeichnet, dass** wenigstens die das Druckausgleichsmittel (4) aufweisende Gehäusewand (3) durch Zweikomponenten-Spitzgießen gefertigt wird.

11. Verfahren nach Anspruch 10, **dadurch gekennzeichnet, dass** als Komponente für die Gehäusewand (3) ein thermoplastischer Kunststoff und als Komponente für das Druckausgleichsmittel (4) ein thermoplastisches Elastomer verwendet werden.
